# EUROPEAN PATENT APPLICATION

(11) **EP 2 509 122 A2**
(43) Date of publication of application: **10.10.2012**
(21) Application number: 12162513.1
(22) Date of filing: 30.03.2012
(51) Int. Cl.: H01L 33/50, H01L 33/54

(54) **Encapsulating sheet, light emitting diode device, and a method for producing the same**

(30) Priority: 05.04.2011 JP 2011084026
(71) Applicant: Nitto Denko Corporation, Osaka 567-8680 (JP)
(72) Inventor: Katayama, Hiroyuki, Osaka, 567-8680 (JP); Kimura, Ryuichi, Osaka, 567-8680 (JP); Kono, Hiroki, Osaka, 567-8680 (JP)
(74) Representative: HOFFMANN EITLE

(57) **Abstract**

An encapsulating sheet (1) is stuck to a substrate (14) mounted with a light emitting diode (11) to encapsulate the light emitting diode. The encapsulating sheet includes an encapsulating material layer (2) in which an embedding region (20) is defined, the embedding region for embedding the light emitting diode from one side surface of the encapsulating material layer; a first phosphor layer (4) laminated on the other side surface of the encapsulating material layer; and a second phosphor layer (5) laminated on one side surface of the encapsulating material layer so as to be spaced apart from the embedding region.

## Description

### BACKGROUND OF THE INVENTION

### Field of the Invention

The present invention relates to an encapsulating sheet, a light emitting diode device, and a method for producing the light emitting diode device. More specifically, the present invention relates to a light emitting diode device used for optical applications, a method for producing the same, and an encapsulating sheet used therein.

### Description of Related Art

In recent years, white light emitting devices are known as light emitting devices capable of emitting high energy light. A white light emitting device is provided with, for example, an LED (light emitting diode) which emits blue light; a phosphor layer which can convert blue light into yellow light and covers the LED; and an encapsulating layer which is arranged adjacent to the phosphor layer to encapsulate the LED. Such white light emitting device emits white light of high energy by mixing the blue light that is emitted from the LED encapsulated with the encapsulating layer and is then transmitted through the encapsulating layer and the phosphor layer, and the yellow light obtained by converting a wavelength of a portion of the blue light through the phosphor layer.

As the white light emitting device, for example, an array package has been proposed in which a semiconductor encapsulating sheet including a second resin layer made of silicone resin and a first resin layer including a silicone elastomer and a yellow phosphor provided on the second resin layer is arranged on an array substrate mounted with a blue LED chip so that the second resin layer is in contact with the blue LED chip (cf. Japanese Unexamined Patent Publication No. 2010-123802).

In the array package disclosed in Japanese Unexamined Patent Publication No. 2010-123802, the second resin layer encapsulates the blue LED chip and, of the lights emitted from the light emitting diode, the blue light transmitted through the first resin layer and the yellow light obtained by wavelength conversion with the first resin layer are mixed to emit white light.

### SUMMARY OF THE INVENTION

With the array package of Japanese Unexamined Patent Publication No. 2010-123802, the light emitted from the blue LED chip is radially spread, so that depending on the angle of the emitted light with respect to the array substrate, some lights pass through the first resin layer, but some are not even though they pass through the second resin layer. If such lights exist, variations in the chromaticity of the light emitted from the array package can disadvantageously increase.

It is an object of the present invention to provide an encapsulating sheet capable of reducing variations in chromaticity while improving encapsulating property to a light emitting diode, a light emitting diode device, and a method for producing the light emitting diode device.

The encapsulating sheet of the present invention is an encapsulating sheet for sticking to a substrate mounted with a light emitting diode and encapsulating the light emitting diode, and includes an encapsulating material layer in which an embedding region is defined, the embedding region for embedding the light emitting diode from one side surface of the encapsulating material layer; a first phosphor layer laminated on the other side surface of the encapsulating material layer; and a second phosphor layer laminated on one side surface of the encapsulating material layer so as to be spaced apart from the embedding region.

In the encapsulating sheet of the present invention, it is preferable that the encapsulating material layer has a tensile modulus at 25°C of 0.01 MPa or more.

It is preferable that the encapsulating sheet of the present invention further includes an adhesive layer laminated on a surface of the second phosphor layer.

The method for producing the light emitting diode device according to the present invention includes the step of sticking an encapsulating sheet to a substrate mounted with a light emitting diode to encapsulate the light emitting diode, the encapsulating sheet includes an encapsulating material layer in which an embedding region is defined, the embedding region for embedding the light emitting diode from one side surface of the encapsulating material layer; a first phosphor layer laminated on the other side surface of the encapsulating material layer; and a second phosphor layer laminated on one side surface of the encapsulating material layer so as to be spaced apart from the embedding region.

In the method for producing the light emitting diode device according to the present invention, it is preferable that the encapsulating sheet is stuck to the substrate so that an end portion in a direction perpendicular to a thickness direction of the encapsulating material layer overflows outwardly by heating to stick to the substrate.

The light emitting diode device of the present invention includes a substrate; a light emitting diode mounted on a surface of the substrate; and the above-mentioned encapsulating sheet stuck on the surface of the substrate to encapsulate the light emitting diode.
The light emitting diode device of the present invention includes a substrate; a light emitting diode mounted on a surface of the substrate; and an encapsulating sheet stuck on the surface of the substrate to encapsulate the light emitting diode, and the encapsulating sheet includes an encapsulating material layer in which an embedding region is defined, the embedding region for embedding the light emitting diode from one side surface of the encapsulating material layer; a first phosphor layer laminated on the other side surface of the encapsulating material layer; and a second phosphor layer laminated on one side surface of the encapsulating material layer so as to be spaced apart from the embedding region.

In the encapsulating sheet of the present invention, since the second phosphor layer is spaced apart from the embedding region, the second phosphor layer is prevented from coming into contacting with the embedding region, so that the embedding region of the encapsulating material layer can reliably embed the light emitting diode. Therefore, the encapsulating sheet can improve encapsulating property of the encapsulating material layer to the light emitting diode.

Besides, in the encapsulating sheet of the present invention, the second phosphor layer is laminated on one side surface of the encapsulating material layer and the first phosphor layer is laminated on the other side surface thereof. Therefore, in the light emitting diode device having such encapsulating sheet stuck thereto, since a light radially spread from the light emitting diode is converted its wavelength by the second phosphor layer as well, a light which does not pass through the phosphor layers can be reduced.

As a result, variation in the chromaticity of light emitted from the light emitting diode device can be reduced.

According to the method for producing the light emitting diode device of the present invention using the encapsulating sheet of the present invention, the light emitting diode can be securely encapsulated, thereby allowing the light emitting diode device of the present invention to be reliably obtained.

### BRIEF DESCRIPTION OF THE DRAWINGS

FIG. 1 is a process diagram explaining a method for producing an embodiment of a encapsulating sheet according to the present invention,
   (a) showing the step of preparing a mold releasing base material,
   (b) showing the step of forming a second phosphor layer,
   (c) showing the step of forming an encapsulating material layer, and
   (d) showing the step of laminating a first phosphor layer;
FIG. 2 is a process diagram explaining a method for producing a light emitting diode device by encapsulating a light emitting diode using the encapsulating sheet shown in FIG. 1(d),
   (a) showing the step of preparing an encapsulating sheet and a light emitting diode, and
   (b) showing the step of sticking the encapsulating sheet to a substrate to encapsulate the light emitting diode;
FIG. 3 shows a sectional view explaining a state in which the peripheral end of an encapsulating material layer outwardly overflows by heating to thereby sticking to a substrate in the step of encapsulating the light emitting diode shown in FIG. 2(b);
FIG. 4 is a process diagram explaining a method for producing a light emitting diode device by encapsulating a light emitting diode using another embodiment (a mode in which an adhesive layer is provided) of the encapsulating sheet according to the present invention,
   (a) showing the step of preparing an encapsulating sheet and a light emitting diode, and
   (b) showing the step of adhering an encapsulating sheet to a substrate via an adhesive layer to thereby encapsulate a light emitting diode;
FIG. 5 is a process diagram explaining a method for producing a light emitting diode device by encapsulating a light emitting diode using the encapsulating sheet of Comparative Example,
   (a) showing the step of preparing an encapsulating sheet and a light emitting diode, and
   (b) showing the step of sticking the encapsulating sheet to a substrate to encapsulate the light emitting diode; and
FIG. 6 shows a schematic view explaining determination of CIE chromaticity index (y value) of a light emitting diode device in the evaluation of Examples.

### DETAILED DESCRIPTION OF PREFERRED EMBODIMENTS

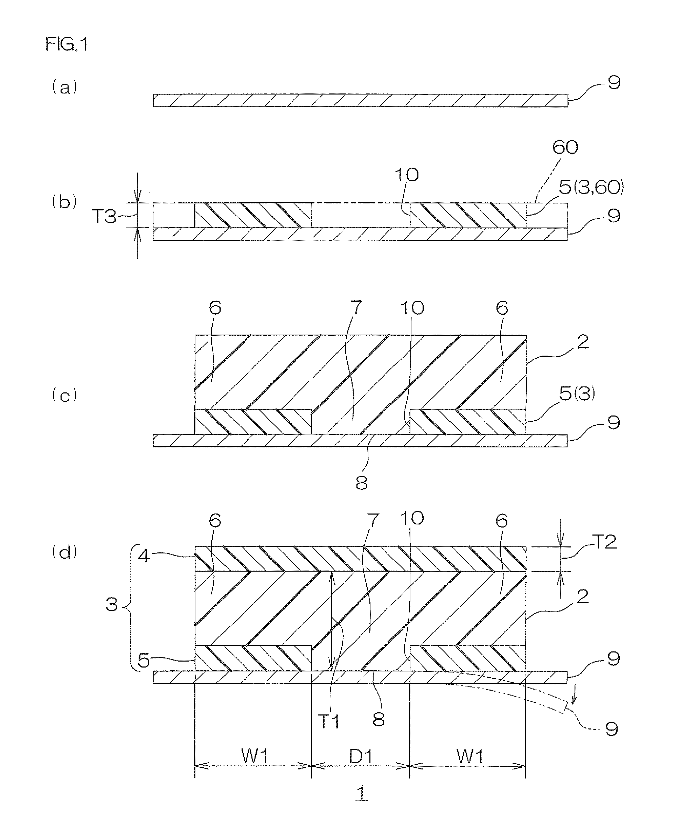

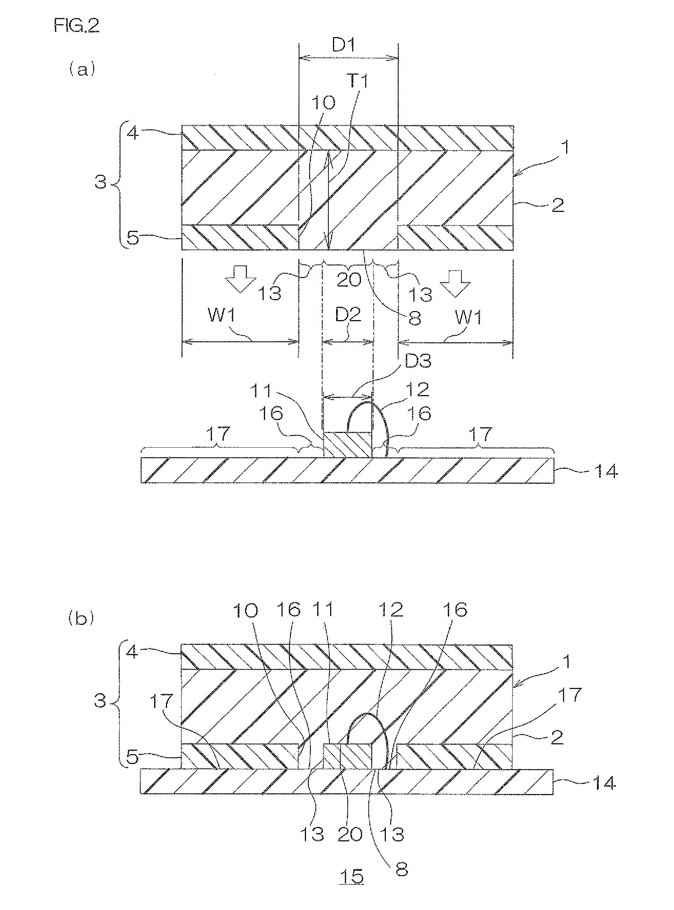

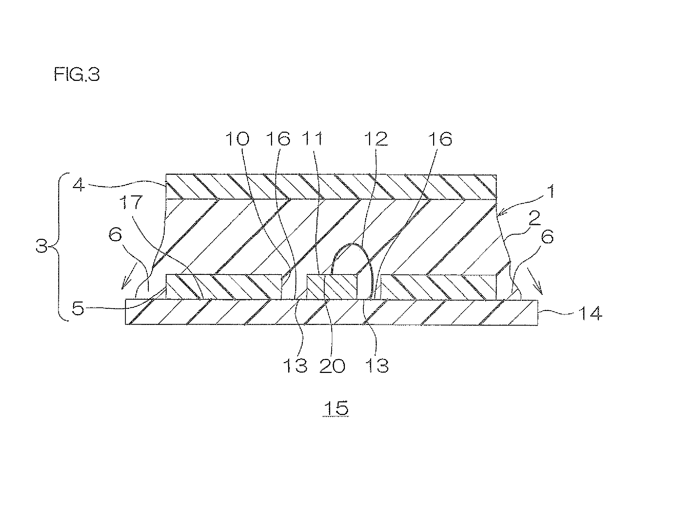

FIG. 1 is a process diagram explaining a method for producing an embodiment of an encapsulating sheet according to the present invention, FIG. 2 is a process diagram explaining a method for producing a light emitting diode device by encapsulating a light emitting diode using the encapsulating sheet shown in FIG. 1(d), and FIG. 3 shows a sectional view explaining a state in which the peripheral end of an encapsulating material layer outwardly overflows by heating to thereby sticking to a substrate in the step of encapsulating the light emitting diode shown in FIG. 2(b).

As shown in FIGS. 1(d) and 2(a), the encapsulating sheet 1 includes an encapsulating material layer 2 and a phosphor layer 3 laminated on a lower surface (one side surface in thickness direction) of the encapsulating material layer 2 and a upper surface (the other side surface in thickness direction) thereof.

The encapsulating material layer 2 is formed in a generally flat sheet-like shape.

The encapsulating member that forms the encapsulating material layer 2 is, for example, a transparent resin, and specific examples thereof include encapsulating resin compositions such as thermosetting resin compositions including silicone resin and epoxy resin; and thermoplastic resin compositions including acrylic resin. As the encapsulating member, a thermosetting resin composition is preferable, or a silicone resin is more preferable from the viewpoint of durability.

A silicone resin contains a silicone elastomer and, for example, a thermosetting silicone resin is used. Examples of the thermosetting silicone resin include a silicone resin composition, a boron compound-containing silicone resin composition, and an aluminum compound-containing silicone resin composition.

The silicone resin composition is a resin which can be subjected to a condensation reaction and an addition reaction (specifically, a hydrosilylation reaction), more specifically, a resin which can be formed in a B-stage state (semi-cured state) by a condensation reaction with heating and can then be formed in a cured (completely cured) state by an addition reaction with further heating.

The silicone resin composition contains, for example, a polysiloxane having silanol groups at both ends, an alkenyl group-containing alkoxysilane, an epoxy group-containing alkoxysilane, an organohydrogensiloxane, a condensation catalyst and an addition reaction catalyst. The polysiloxane having silanol groups at both ends, the alkenyl group-containing alkoxysilane, and the epoxy group-containing alkoxysilane are condensation raw materials (raw materials subjected to a condensation reaction), while the alkenyl group-containing alkoxysilane and the organohydrogensiloxane are addition raw materials (raw materials subjected to an addition reaction).

The polysiloxane having silanol groups at both ends is a silane compound which contains a silanol group (SiOH group) at both ends of a molecule, and is specifically represented by the following formula (1):

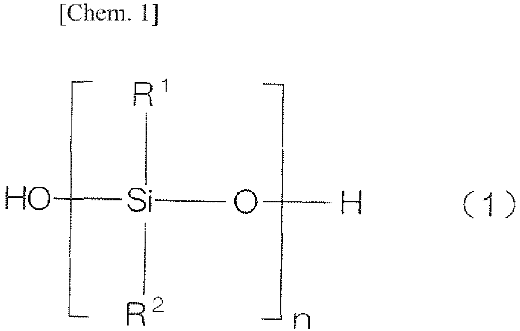

(in the formula (1), R¹ and R² each represents a monovalent hydrocarbon group, n represents an integer of 2 or more, and R¹ and R² is the same or different from each other.)

In the above formula (1), R¹ and R² is preferably the same.

Examples of the monovalent hydrocarbon group represented by R¹ and R² include saturated or unsaturated, linear, branched, or cyclic hydrocarbon groups. The number of carbon atoms of the hydrocarbon group is, for example, from 1 to 20, or preferably from 1 to 10, from the viewpoint of ease of preparation or thermal stability.

Specific examples of the monovalent hydrocarbon group include saturated aliphatic hydrocarbon groups such as methyl, ethyl, propyl, isopropyl, butyl, isobutyl, pentyl, cyclopentyl, hexyl, and cyclohexyl; and aromatic hydrocarbon groups such as phenyl and naphthyl.

Of these monovalent hydrocarbon groups, a saturated aliphatic hydrocarbon group is preferable, or methyl is more preferable, from the viewpoints of transparency and light resistance.

In the above formula (1), n is preferably an integer of 2 to 10000 from the viewpoint(s) of stability and/or handleability, or more preferably an integer of 2 to 1000.

Specific examples of the polysiloxane having silanol groups at both ends include polydimethylsiloxane having silanol groups at both ends, polymethylphenylsiloxane having silanol groups at both ends, and polydiphenylsiloxane having silanol groups at both ends. Of these, polydimethylsiloxane having silanol groups at both ends is preferable.

Commercially available (polysiloxane having silanol groups at both ends can be used, and those synthesized according to known methods can also be used.

These polysiloxanes having silanol groups at both ends can be used alone or in combination of two or more kinds.

The (polysiloxane having silanol groups at both ends is usually a mixture of compounds having different n (i.e., different molecular weights).

Therefore, n in the above formula (1) is calculated as an average value.

The polysiloxane having silanol groups at both ends has a number average molecular weight of, for example, 100 to 1,000,000, or preferably 200 to 100,000, from the viewpoint(s) of stability and/or handleability. The number average molecular weight thereof is determined in terms of standard polystyrene by gel permeation chromatography. The number average molecular weight of the raw materials to be described later other than polysiloxane having silanol groups at both ends are also calculated in the same manner as above.

The polysiloxane having silanol groups at both ends is blended at a ratio of, for example, 1 to 99.99% by mass, preferably 50 to 99.9% by mass, or more preferably 80 to 99.5% by mass, of the total amount of the condensation raw materials.

The alkenyl group-containing alkoxysilane is a silane compound having both an alkenyl group and an alkoxy group, and is specifically an alkenyl group-containing trialkoxysilane represented by the following formula (2):

R³-Si(OR⁴)₃ (2)

(in the formula (2), R³ is a linear or cyclic alkenyl group, and R⁴ is a monovalent hydrocarbon group. R³ and R⁴ are different from each other.)

The number of carbon atoms of the alkenyl group represented by R³ is, for example, from 2 to 20, or preferably from 2 to 10, from the viewpoint of ease of preparation or thermal stability.

Specific examples of the alkenyl group include linear alkenyl groups such as a vinyl group, an allyl group, a propenyl group, a butenyl group, a pentenyl group, a hexenyl group, a heptenyl group, and an octenyl group, and cyclic alkenyl groups such as a norbornenyl group and a cyclohexenyl group.

Of these, a linear alkenyl group is preferable, or from the viewpoint of reactivity of the addition reaction, a vinyl group is more preferable.

Examples of the monovalent hydrocarbon group represented by R⁴ include the same monovalent hydrocarbon groups as those represented by R¹ and R² in the above formula (1). Of these, methyl is preferable.

Specific examples of the alkenyl group-containing alkoxysilane include vinyltrialkoxysilane such as vinyltrimethoxysilane, vinyltriethoxysilane, and vinyltripropoxysilane; allyltrimethoxysilane; propenyltrimethoxysilane; butenyltrimethoxysilane; pentenyltrimethoxysilane; hexenyltrimethoxysilane; heptenyltrimethoxysilane; octenyltrimethoxysilane; norbornenyltrimethoxysilane; and cyclohexenyltrimethoxysilane.

Of these, vinyltrialkoxysilane is preferable, or vinyltrimetoxysilane is more preferable.

These alkenyl group-containing alkoxysilanes can be used alone or in combination of two or more kinds.

Commercially available alkenyl group-containing alkoxysilanes can be used, and those synthesized according to known methods can also be used.

The alkenyl group-containing alkoxysilane is blended at a ratio of, for example, 0.01 to 90% by mass, preferably 0.01 to 50% by mass, or more preferably 0.01 to 10% by mass, of the total amount of the condensation raw materials.

The epoxy group-containing alkoxysilane is a silane compound having both an epoxy group and an alkoxy group, and is specifically an epoxy group-containing trialkoxysilane represented by the following formula (3):

R⁵-Si(OR⁶)₃ (3)

(in the formula (3), R⁵ is a glycidyl ether group, and R⁶ is a monovalent hydrocarbon group.

The glycidyl ether group represented by R⁵ is a glycidoxyalkyl group represented by the following formula (4):

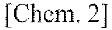

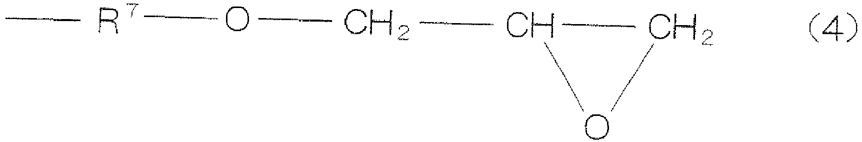

(in the (formula (4), R⁷ is a divalent hydrocarbon group.)

Examples of the divalent hydrocarbon group represented by R⁷ in the above formula (4) include an alkylene group of 1 to 6 carbon atoms such as methylene, ethylene, propylene, and butylene; a cycloalkylene group of 3 to 8 carbon atoms such as cyclohexylene; and an arylene group of 6 to 10 carbon atoms such as phenylene.

As the divalent hydrocarbon group, an alkylene group is preferable, or propylene is more preferable.

Specific examples of the glycidyl ether group represented by R⁵ include glycidoxy methyl, glycidoxy ethyl, glycidoxy propyl, glycidoxy cyclohexyl, and glycidoxy phenyl.

In the above formula (3), examples of the monovalent hydrocarbon group represented by R⁶ include the same monovalent hydrocarbon groups as those represented by R¹ and R² in the above formula (1). Of these, methyl is preferable.

Specific examples of the epoxy group-containing alkoxysilane include glycidoxyalkyl trimethoxysilane such as glycidoxymethyl trimethoxysilane, (2-glycidoxyethyl) trimethoxysilane, and (3-glycidoxypropyl) trimethoxysilane; (3-glycidoxypropyl) triethoxysilane; (3-glycidoxypropyl) tripropoxysilane; and (3-glycidoxypropyl) triisopropoxysilane.

Of these, glycidoxymethyl trialkoxysilane is preferable, or (3-glycidoxypropyl) trimethoxysilane is more preferable.

These epoxy group-containing alkoxysilanes can be used alone or in combination of two or more kinds.

Commercially available epoxy group-containing alkoxysilanes can be used, and those synthesized according to known methods can also be used.

The epoxy group-containing alkoxysilane is blended at a ratio of, for example, 0.01 to 90% by mass, preferably 0.01 to 50% by mass, or more preferably 0.01 to 20% by mass, of the total 100 parts by mass of the condensation raw materials.

The molar ratio (SiOH/(SiOR⁴+ SiOR⁶) of the silanol group (SiOH group) of the polysiloxane having silanol groups at both ends to the alkoxysilyl groups (SiOR⁴ group and SiOR⁶ group) of the alkenyl group-containing alkoxysilane and the epoxy group-containing alkoxysilane is in the range of, for example, 20/1 to 0.2/1, preferably 10/1 to 0.5/1, or more preferably, substantially 1/1.

When the molar ratio exceeds the above range, a B-staged material (a semi-cured material) having moderate toughness may not be obtained in the case of forming the silicone resin composition in the B-stage. On the other hand, when the molar ratio is less than the above range, the blended amounts of the alkenyl group-containing alkoxysilane and the epoxy group-containing alkoxysilane are excessively large, which may result in deterioration in heat resistance of the obtained encapsulating material layer 2.

Further, when the molar ratio is within the above range (preferably, substantially 1/1), the silanol group (SiOH group) of the polysiloxane having silanol groups at both ends can be subjected to condensation reaction with the alkoxysilyl group (SiOR⁴ group) of the alkenyl group-containing alkoxysilane and the alkoxysilyl group (SiOR⁶ group) of the epoxy group-containing alkoxysilane in a proper quantity.

The molar ratio of the alkenyl group-containing alkoxysilane to the epoxy group-containing alkoxysilane is in the range of, for example, 10/90 to 99/1, preferably 50/50 to 97/3, or more preferably 80/20 to 95/5. When the molar ratio is within the above range, there can be provided advantages of improving adhesion while the strength of cured products can be secured.

The organohydrogensiloxane is a compound containing a hydrogen atom directly bonded to a silicon atom in a main chain, and examples thereof include a hydride compound containing a hydrogen atom directly bonded to a silicon atom in the middle (between both ends) of the main chain, which is represented by the following formula (5); or a hydride compound (polysiloxane having hydrosilyl groups at both ends) containing a hydrogen atom directly bonded to silicon atoms at both ends of the main chain, which is represented by the following formula (6):

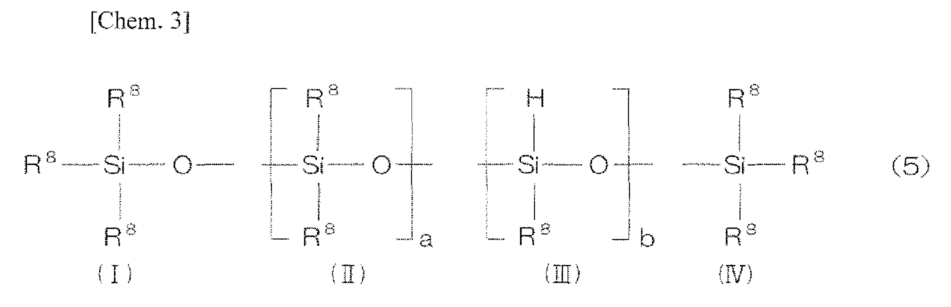

(in the formula (5), I, II, III, and IV are constitutional units, I and IV each represents a terminal unit, II and III each represents a repeating unit, all of R⁸ are the same or different from each other, and each represents a monovalent hydrocarbon group. a represents an integer of 0 or 1 or more, and b represents an integer of 2 or more.)

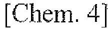

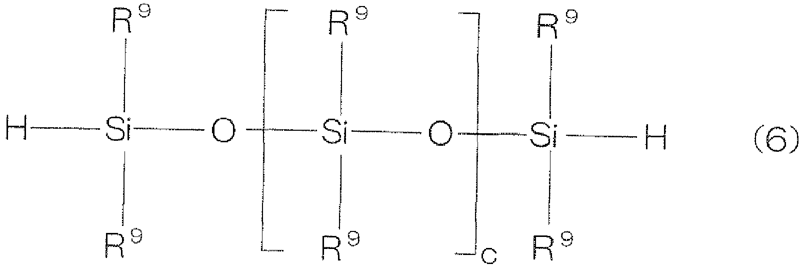

(in the formula (6), all of R⁹ are the same or different from each other and each represents a monovalent hydrocarbon group. c represents an integer of 1 or more.)

R⁸ in constitutional unit I, R⁸ in constitutional unit II, R⁸ in constitutional unit III, and R⁸ in constitutional unit IV are preferably the same.

Examples of the monovalent hydrocarbon group represented by R⁸ include the same monovalent hydrocarbon groups as those represented by R¹ and R² described above. Of these, methyl and ethyl are preferable, or methyl is more preferable.

Constitutional units I and IV each represents a terminal unit at each end.

a in constitutional unit II represents the number of repeating units of constitutional unit II, and represents preferably an integer of 1 to 1000 from the viewpoint of reactivity, or more preferably an integer of 1 to 100.

b in constitutional unit III represents the number of repeating units of constitutional unit III, and represents preferably an integer of 2 to 10000 from the viewpoint of reactivity, or more preferably an integer of 2 to 1000.

Specific examples of the hydride compound represented by the above formula (5) include a methylhydrogenpolysiloxane, a dimethylpolysiloxane-co-methylhydrogenpolysiloxane, an ethylhydrogenpolysiloxane, and a methylhydrogenpolysiloxane-co-methylphenylpolysiloxane. Of these, a dimethylpolysiloxane-co-methylhydrogenpolysiloxane is preferable.

These hydride compounds represented by the above formula (5) can be used alone or in combination of two or more kinds.

The hydride compound represented by the above formula (5) is usually a mixture of compounds having different a and/or b (i.e., different molecular weights).

Therefore, a in constitutional unit I and b in constitutional unit II are each calculated as an average value.

The hydride compound represented by the above formula (5) has a number average molecular weight of, for example, 100 to 1,000,000.

All of R⁹ in the above formula (6) are preferably the same. That is, R⁹ bonded to the silicon atoms at both ends and R⁹ bonded to the silicon atom between both ends are all the same.

Examples of the monovalent hydrocarbon group represented by R⁹ include the same monovalent hydrocarbon groups as those represented by R¹ and R² described above. Of these, methyl and ethyl are preferable.

In the above formula (6), c represents preferably an integer of 1 to 10,000, or more preferably an integer of 1 to 1,000, from the viewpoint of reactivity.

Specific examples of the hydride compound represented by the above formula (6) include polydimethylsiloxane having hydrosilyl groups at both ends, polymethylphenylsiloxane having hydrosilyl groups at both ends, and polydiphenylsiloxane having hydrosilyl groups at both ends.

These hydride compounds represented by the above formula (6) can be used alone or in combination of two or more kinds.

The hydride compound represented by the above formula (6) is usually a mixture of compounds having different c (i.e., different molecular weights).

Therefore, c in the above formula (6) is calculated as an average value.

The hydride compound represented by the above formula (6) has a number average molecular weight of, for example, 100 to 1,000,000, or more preferably 100 to 100,000, from the viewpoint(s) of stability and/or handleability.

The organohydrogensiloxane has a viscosity at 25°C of, for example, 10 to 100,000 mPa·s, or preferably 20 to 50,000 mPa·s. The viscosity can be measured with a E type viscometer (rotor type: 1"34' × R24, number of revolution 10 rpm).

Commercially available organohydrogensiloxane can be used, and those synthesized according to known methods can also be used.

As the organohydrogensiloxane, the hydride compound represented by the above formula (5) or the hydride compound represented by the above formula (6) can be used alone or in combination. Preferably, the hydride compound represented by the above formula (5) is used alone as the organohydrogensiloxane.

The organohydrogensiloxane is blended at a ratio of, for example, 10 to 10,000 parts by mass, or preferably 100 to 1,000 parts by mass, per 100 parts by mass of the alkenyl group-containing alkoxysilane, depending upon the molar ratio of the alkenyl group (R³ in the above formula (2)) of the alkenyl group-containing alkoxysilane to the hydrosilyl group (SiH group) of the organohydrogensiloxane.

The molar ratio (R³/SiH) of the alkenyl group (R³ in the above formula (2)) of the alkenyl group-containing alkoxysilane to the hydrosilyl group (SiH group) of the organohydrogensiloxane is, in the range of, for example, 20/1 to 0.05/1, preferably 20/1 to 0.1/1, more preferably 10/1 to 0.1/1, even more preferably 10/1 to 0.2/1, or most preferably 5/1 to 0.2/1. Moreover, the molar ratio can be set to, for example, less than 1/1 and 0.05/1 or more.

When the molar ratio exceeds 20/1, a semi-cured material having moderate toughness may not be obtained in the case of forming the silicone resin composition in the B-stage state. On the other hand, when the molar ratio is less than 0.05/1, the blended amount of the organohydrogensiloxane is excessively large, which may result in poor heat resistance and toughness of the obtained phosphor layer 3.

Further, when the molar ratio is less than 1/1 and 0.05/1 or more, the silicone resin composition can be shifted to the B-stage more quickly than a silicone resin composition having a molar ratio of 20/1 to 1/1 in the case of forming the silicone resin composition in the B-stage.

There is no particular limitation on the condensation catalyst as long as it is a compound which can increase the reaction rate of the condensation reaction between the silanol group and the alkoxysilyl group, and examples thereof include acids such as hydrochloric acid, acetic acid, formic acid, and sulfuric acid; bases such as potassium hydroxide, sodium hydroxide, potassium carbonate, and tetramethylammonium hydroxide; and metal catalysts such as aluminum, titanium, zinc, and tin.

Of these, bases are preferable, or tetramethylammonium hydroxide is more preferable, from the viewpoints of compatibility and thermal decomposition property.

The condensation catalyst is blended at a ratio of, for example, 0.1 to 50 mol, or preferably 0.5 to 5 mol, per 100 mol of the polysiloxane having silanol groups at both ends.

There is no particular limitation on the addition reaction catalyst as long as it is a compound (a hydrosilylation catalyst) which can increase the reaction rate of the addition reaction, i.e., a hydrosilylation reaction between the alkenyl group and SiH, and examples thereof include metal catalysts such as platinum catalysts such as platinum black, platinum chloride, chloroplatinic acid, a platinum-olefin complex, a platinum-carbonyl complex, and platinum-acetyl acetate; palladium catalyst; rhodium catalyst.

Of these, platinum catalysts are preferable, or a platinum-carbonyl complex is more preferable, from the viewpoints of compatibility, transparency, and catalytic activity.

The addition reaction catalyst is blended at a ratio of, for example, 1.0 x 10⁻⁴ to 1.0 part by mass, preferably 1.0 x 10⁻⁴ to 0.5 parts by mass, or more preferably 1.0 x 10⁻⁴ to 0.05 parts by mass, per 100 parts by mass of the organohydrogensiloxane, in terms of the amount of metal in the addition reaction catalyst.

The above-mentioned catalyst may be used as in a solid state or can be used in the form of a solution or dispersion dissolved or dispersed in a solvent, from the viewpoint of handleability.

Examples of the solvent include organic solvents such as alcohols including methanol and ethanol; silicon compounds including siloxane; aliphatic hydrocarbons including hexane; aromatic hydrocarbons including toluene; and ethers including tetrahydrofuran (THF). Examples of the solvent also include water-based solvents such as water.

When the catalyst is a condensation catalyst, alcohol is used preferably; and when the catalyst is an addition catalyst, silicon compounds and aromatic hydrocarbons are used preferably.

The silicone resin composition is prepared by blending the above-mentioned polysiloxane having silanol groups at both ends, alkenyl group-containing alkoxysilane, epoxy group-containing alkoxysilane, and organohydrogensiloxane with a catalyst (the condensation catalyst and the addition reaction catalyst), and then mixing them with stirring.

To prepare the silicone resin composition, for example, the above-mentioned raw materials (the condensation raw materials and the addition raw materials) and the catalysts are added at once. Alternatively, the raw materials and the catalysts can be first added at different timings. In another alternative process, some components can be added at once and the remaining components can also be added at different timings.

Preferably, the condensation raw materials and the condensation catalyst are first added at once, and the addition raw materials are then added thereto. Subsequently, the addition reaction catalyst is added thereto.

Specifically, the condensation catalyst is blended at once with the polysiloxane having silanol groups at both ends, the alkenyl group-containing alkoxysilane, and epoxy group-containing alkoxysilane (i.e., condensation raw materials) at the above proportion, and the mixture is stirred, for example, for 5 minutes to 24 hours.

During blending and stirring, the temperature can be set to, for example, 0 to 60°C in order to improve the compatibility and handleability of the condensation raw materials.

In addition, during blending of the raw materials and the condensation catalyst, a compatibilizer for improving their compatibility can be added at an appropriate proportion.

Examples of the compatibilizer include organic solvents such as alcohols including methanol. In addition, when the condensation catalyst is prepared as a solution or a dispersion of an organic solvent, the organic solvent can be applied as the compatibilizer.

Thereafter, the system is depressurized as required, to thereby remove a volatile component (organic solvent).

Next, an organohydrogensiloxane is blended with thus obtained mixture of the condensation raw materials and the condensation catalyst, and the blended mixture is stirred, for example, for 1 to 60 minutes.

During blending and stirring, the mixture may be heated to, for example, 0 to 60°C in order to improve the compatibility and handleability of the mixture and the organohydrogensiloxane.

Subsequently, the addition catalyst is blended with the system, and the blended mixture is stirred, for example, for 1 to 60 minutes.

Thus, the silicone resin composition can be prepared.

The boron compound-containing silicone resin composition contains, for example, a polysiloxane having silanol groups at both ends and a boron compound.

Examples of the polysiloxane having silanol groups at both ends include the same polysiloxane as that represented by the above formula (1).

Specific examples of the boron compound include the borate compound represented by the following formula (7):

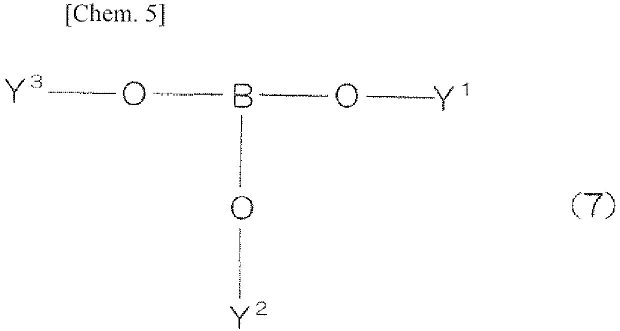

(in the formula (7), Y¹, Y², and Y³ each independently represents hydrogen or an alkyl group.)

The number of carbon atoms of the alkyl groups represented by Y¹, Y², and Y³ is, for example, from 1 to 12, preferably from 1 to 6, or more preferably from 1 to 3.

Specific examples of the alkyls represented by Y¹, Y², and Y³ include methyl, ethyl, propyl, and isopropyl. Of these, ethyl and isopropyl are preferable, or isopropyl is more preferable.

Specific examples of the boron compound include acids such as boric acid; and borate triester such as trimethyl borate, triethyl borate, tripropyl borate, and triisopropyl borate.

These boron compounds can be used alone or in combination of two or more kinds.

The polysiloxane having silanol groups at both ends and the boron compound are blended at a mass ratio (parts by mass of the polysiloxane having silanol groups at both ends/parts by mass of the boron compound) of the polysiloxane having silanol groups at both ends to the boron compound of, for example, 95/ 5 to 30/70, preferably 95/5 to 50/50, more preferably 95/5 to 60/40, or even more preferably 95/5 to 70/30, from the viewpoints of heat resistance, transparency, and light resistance.

The molar ratio (Si/B) of the silicon atom of the polysiloxane having silanol groups at both ends to the boron atom of the borate compound is in the range of, for example, 2/1 to 1000/1, preferably 4/1 to 500/1, or more preferably 6/1 to 200/1.

When the molar ratio is less than the above range, the encapsulating material layer 2 in the B-stage is excessively hardened. On the other hand, when the molar ratio exceeds the above range, the encapsulating material layer 2 in the B-stage state becomes excessively soft, which may result in deterioration in workability.

The boron compound-containing silicone resin composition is prepared by blending the polysiloxane having silanol groups at both ends and the boron compound at the above ratio, and then mixing them with stirring at room temperature.

It is noted that the boron compound-containing silicone resin composition can also be prepared according to the descriptions in Japanese Unexamined Patent Publication Nos. 2009-127021 and 2009-127020.

The aluminum compound-containing silicone resin composition contains, for example, a polysiloxane having silanol groups at both ends and an aluminum compound.

Examples of the polysiloxane having silanol groups at both ends include the same polysiloxane as that represented by the above formula (1).

Specifically, the aluminum compound is represented by the following formula (8):

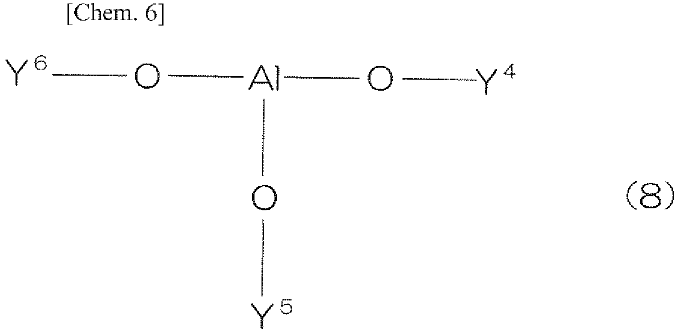

(in the formula (8), Y⁴, Y⁵, and Y⁶ each independently represents hydrogen or an alkyl group.)

The number of carbon atoms of the alkyl groups represented by Y⁴, Y⁵, and Y⁶ is, for example, from 1 to 12, preferably from 1 to 6, or more preferably from 1 to 3.

Specific examples of the alkyl groups represented by Y⁴, Y⁵, and Y⁶ include a methyl group, an ethyl group, a propyl group, and an isopropyl group. Of these, an ethyl group and an isopropyl group are preferable, or isopropyl is more preferable.

Examples of the aluminum compound include aluminum trialkoxides such as aluminum trimethoxide, aluminum triethoxide, aluminum tripropoxide, aluminum triisopropoxide, and aluminum tributoxide.

These aluminum compounds can be used alone or in combination of two or more kinds.

Of these, aluminium triisopropoxide is preferable.

The polysiloxane having silanol groups at both ends and the aluminum compound are blended at a mass ratio of the polysiloxane having silanol groups at both ends to the aluminum compound (the polysiloxane having silanol groups at both ends/the aluminum compound) of, for example, 99/1 to 30/70, or preferably 90/10 to 50/50.

The molar ratio (Si/Al) of the silicon atom of the polysiloxane having silanol groups at both ends to the aluminum atom of the aluminum compound is in the range of, for example, 2/1 to 1000/1, preferably 4/1 to 500/1, or more preferably 6/1 to 200/1.

When the molar ratio is less than the above range, the encapsulating material layer 2 in the B-stage is excessively hardened. On the other hand, when the molar ratio exceeds the above range, the encapsulating material layer 2 in the B-stage becomes excessively soft, which may result in deterioration in workability.

The aluminum compound-containing silicone resin composition is prepared by blending the polysiloxane having silanol groups at both ends and the aluminum compound at the above ratio, and then mixing them with stirring at room temperature.

It is noted that the aluminum compound-containing silicone resin composition can also be prepared according to the descriptions in Japanese Unexamined Patent Publication Nos. 2009-127021 and 2009-235376.

A known additive such as a transmission inhibitor, a modifying agent, a surfactant, a dye, a pigment, a discoloration preventing agent, or an ultraviolet absorber can be added to the above-mentioned encapsulating member in an appropriate proportion.

In the case where the encapsulating material layer 2 is formed of thermosetting resin composition (preferably, silicone resin), a thermosetting resin composition in the B-stage (semi-cured) is preferably used.

The encapsulating material layer 2 (the encapsulating material layer 2 in the B-stage state) has a tensile modulus at 25°C of, for example, 0.01 MPa or more, or preferably 0.01 to 0.1 MPa, from the viewpoints of encapsulating property and handleability.

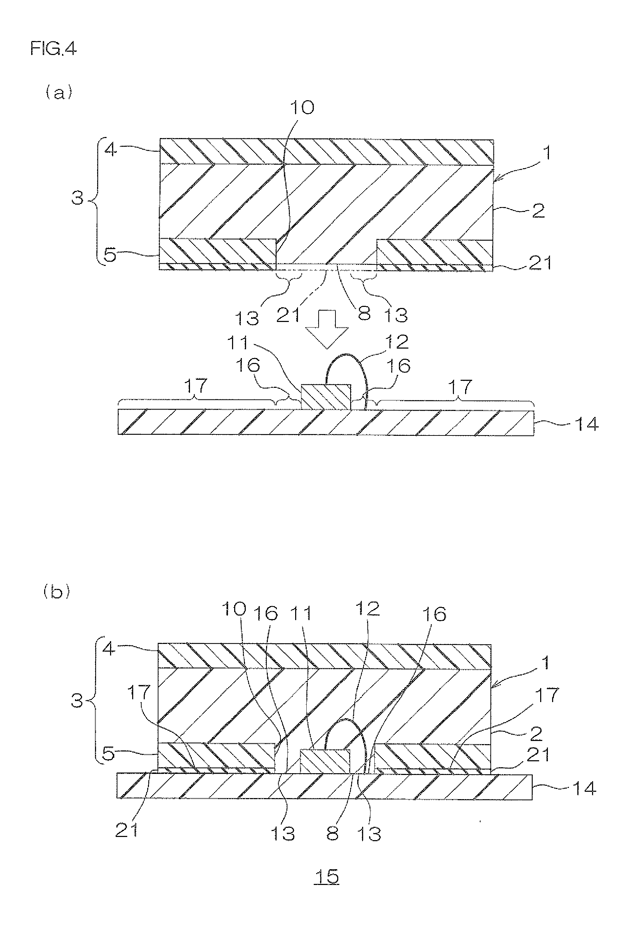

The encapsulating material layer 2 has a tensile modulus at 25°C of less than the lower limit described above, the retention of shape of the encapsulating material layer 2 may be deteriorated. Further, when the encapsulating material layer 2 has a tensile modulus at 25°C within the above range, a light emitting diode 11 (to be described later, see FIG. 4) can reliably be embedded and a wire 12 and the light emitting diode 11 can also be prevented from being damaged.

The tensile modulus of the encapsulating material layer 2 is determined by a tensile test using a universal tensile testing machine (specifically, an autograph).

The tensile modulus of the encapsulating material layer 2 is not limited to the tensile direction, and for example, the tensile modulus in the thickness direction of the encapsulating material layer 2 and the tensile modulus in the plane direction (a direction perpendicular to the thickness direction, that is, a left-and-right and a depth directions in FIGS. 1 and 2) thereof are substantially the same.

The encapsulating material layer 2 has a thickness T1 (a maximum thickness, i.e., a length between the upper surface of a mold releasing base material 9 and the lower surface of a first phosphor layer 4), which is adjusted so that the light emitting diode I 1 and the wire 12 can be embedded at the time of encapsulating the light emitting diode 11 to be described later, specifically of, for example, 300 to 3000 µm, or preferably 500 to 2000 µm.

The phosphor layer 3 contains a phosphor, and examples of the phosphor include a yellow phosphor capable of converting blue light into yellow light. As such phosphor, a phosphor having composite metal oxide or metal sulfide doped with metal atoms such as cerium (Ce) and europium (Eu) is used.

Specific examples of the phosphor include garnet type phosphors having garnet crystal structure such as Y₃Al₅O₁₂:Ce (YAG(yttrium aluminum garnet):Ce), (Y, Gd)₃Al₅O₁₂:Ce, Tb₃Al₃O₁₂:Ce, Ca₃Sc₂Si₃O₁₂:Ce, and Lu₂CaMg₂ (Si, Ge)₃O₁₂:Ce; silicate phosphors such as (Sr, Ba)₂SiO₄:Eu, Ca₃SiO₄Cl₂Eu, Sr₃SiO₅:Eu, Li₂SrSiO₄:Eu, and Ca₃Si₂O₇:Eu; aluminate phosphors such as CaAl₁₂O₁₉:Mn and SrAl₂O₄:Eu; sulfide phosphors such as ZnS:Cu, Al, CaS:Eu, CaGa₂S₄:Eu, and SrGa₂S₄:Eu; oxynitride phosphors such as CaSi₂O₃N₂:Eu, SrSi₂O₂N₂:Eu, BaSi₂O₂N₂:Eu, and Ca-α-SiAlON; nitride phosphors such as CaAlSiN₃:Eu and CaSi₅N₈:Eu; and fluoride phosphors such as K₂SiF₆:Mn and K₂TiF₆:Mn. Of these, garnet type phosphors are preferable from the viewpoint of the property of converting blue light into yellow light, or Y₃Al₅O₁₂:Ce is more preferable from the viewpoint of conversion efficiency.

These phosphors can be used alone or in combination of two or more kinds.

The phosphor is in a particulate form. The shape thereof is not particularly limited, and examples thereof include a generally spherical shape, a generally planar shape, and a generally needle-like shape.

The phosphor has an average particle size (an average of the maximum length) of, for example, 0. 1 to 500 µm, or preferably 0.2 to 200 µm. The average particle size of the phosphor particle is measured with a size distribution measuring device.

The phosphor layer 3 is formed of a phosphor-containing resin composition which is obtained by blending the above-mentioned phosphor with a resin.

As such resin, the same transparent resins as those used for the above-mentioned encapsulating member is used. Of these, a thermosetting resin composition is preferable, or a silicone resin composition is more preferable. The thermosetting resin composition is preferably in a B-stage (semi-cured).

The phosphor-containing resin composition is prepared by blending the phosphor and the resin (preferably a thermosetting resin) described above and then mixing them with stirring. Specifically, a phosphor and a resin are blended, and the blended mixture is then mixed using a stirrer such as a magnetic stirrer, a mechanical stirrer, or a hybrid mixer, so that the phosphor is uniformly dispersed in the resin.

The stirring temperature is, for example, from room temperature (approximately 25°C) to 50°C, and the stirring time is, for example, from 1 minute to 180 minutes.

The phosphor is blended at a ratio of, for example, 1 to 50% by mass, or preferably 10 to 40% by mass, to the phosphor-containing resin composition.

As shown in FIGS. 1 (d) and 2(a), the phosphor layer 3 includes a second phosphor layer 5 laminated on the lower surface (one side surface in thickness direction) of the encapsulating material layer 2 and a first phosphor layer 4 laminated on the upper surface (the other side surface in thickness direction) thereof.

The first phosphor layer 4 is laminated on the entire upper surface of the encapsulating material layer 2.

The first phosphor layer 4 has a thickness T2 (see FIG. 1(d)) of, for example, 50 to 500 µm, or preferably 50 to 150 µm.

The second phosphor layer 5 is laminated on the lower surface of a peripheral end portion 6 of the encapsulating material layer 2, that is, the lower surface of an outer end portion in the plane direction thereof.

The second phosphor layer 5 has an opening 10 formed in the center in the plane direction having a generally circular shape in bottom view penetrating in the thickness direction, and the opening 10 in the second phosphor layer 5 is filled with the encapsulating material layer 2.

Thus, a center portion 7 of the encapsulating material layer 2 is slightly protruded downward and a lower surface of a protruded portion 8 is exposed from the opening 10 in the second phosphor layer 5.

As referred to FIG. 2(a), when the encapsulating sheet 1 and a substrate 14 are opposed to each other, the protruded portion 8 of the encapsulating material layer 2 is formed in a pattern allowing the light emitting diode 11 and the wire 12, which are described later, to be included when projected in the thickness direction, and specifically, the protruded portion 8 is formed in a generally circular shape in bottom view which is larger than the light emitting diode 11 and the wire 12.

The second phosphor layer 5 is formed in a generally frame-like (annular) shape in bottom view surrounding the periphery of the protruded portion 8 of the encapsulating material layer 2.

The lower surface of the second phosphor layer 5 is formed flush with the lower surface of the protruded portion 8 of the encapsulating material layer 2 in the plane direction.

An inner diameter D1 of the opening 10 in the second phosphor layer 5 is appropriately set depending on the size of the light emitting diode 11 I to be described later and is, for example, from 0.1 to 100 mm, or preferably from 0.1 to 10 mm. A width (a length in plane direction) W1 of the second phosphor layer 5 is appropriately set depending on the size of the substrate 14 and is, for example, from 1 to 50 mm, or preferably from 1 to 20 mm.

The second phosphor layer 5 has a thickness T3 (see FIG. 1(b)) of, for example, 50 to 500 µm, or preferably 50 to 150 µm.

The first phosphor layer 4 and the second phosphor layer 5 are formed of components (a phosphor and a resin) which form the above-mentioned phosphor layer 3.

Next, a method for producing the above-mentioned encapsulating sheet 1 is described with reference to FIG. 1.

In this method, a mold releasing base material 9 is first prepared, as shown in FIG. 1 (a).

The mold releasing base material 9 is shaped into a generally flat, rectangular sheet form, and is formed of, for example, a resin material such as polyolefin (e.g., polyethylene, polypropylene, etc.) and polyester (e.g., polyethylene terephtalate, polycarbonate, etc.); or a metal material such as iron, aluminum, and stainless steel. Of these, a resin material is preferably used.

The surface (upper surface) of the mold releasing base material 9 is subjected to a mold release treatment as required in order to improve mold releasability from the encapsulating material layer 2 and a second phosphor layer 5.

Subsequently, as shown in FIG. 1(b), the second phosphor layer 5 is laminated on the upper surface of the mold releasing base material 9 in the above-mentioned pattern.

To laminate the second phosphor layer 5 on the upper surface of the mold releasing base material 9 in the above-mentioned pattern, first, as shown in phantom lines in FIG. 1(b), a phosphor-containing resin composition is applied onto the entire upper surface of the mold releasing base material 9 by a known coating method such as casting, spin coating, roll coating, and employing an applicator, to thereby form a phosphor-containing coating 60.

Thereafter, the center portion and the peripheral portion of the phosphor-containing coating 60 are removed, for example, by half cutting, etching, or the like. As shown in solid lines in FIG. 1(b), the phosphor-containing coating 60 is thus patterned into the above-mentioned generally frame-like (annular) shape.

Therefore, the phosphor-containing coating 60 is formed in a pattern having the opening 10.

Thereafter, the phosphor-containing coating 60 is heated to be cured, so that the second phosphor layer 5 in a cured state is formed. The heating temperature is, for example, from 50 to 150°C and the heating time is, for example, from I to 100 minutes.

As shown in FIG. 1(c), the encapsulating material layer 2 is then laminated on the upper surfaces of the mold releasing base material 9 and the second phosphor layer 5. Specifically, the encapsulating material layer 2 is laminated on the upper surface of the mold releasing base material 9 exposed from the second phosphor layer 5 and the upper surface of the second phosphor layer 5. In other words, the encapsulating material layer 2 is laminated on the upper surface of the second phosphor layer 5 so as to fill in the opening 10 in the second phosphor layer 5.

To laminate the encapsulating material layer 2 on the upper surfaces of the mold releasing base material 9 and the second phosphor layer 5, the above-mentioned encapsulating member (the encapsulating resin composition) is applied onto the entire upper surface of the second phosphor layer 5 containing the mold releasing base material 9, for example, by the above-mentioned coating method, to thereby form an encapsulating coating (not shown).

Subsequently, the encapsulating coating is heated to form the encapsulating material layer 2 made of the encapsulating resin composition in the B-stage. The heating temperature is, for example, from 50 to 150°C and the heating time is, for example, from 1 to 100 minutes.

Thus, the encapsulating material layer 2 is laminated on the upper surfaces of the mold releasing base material 9 and the second phosphor layer 5.

Next, as shown in FIG. 1 (d), the first phosphor layer 4 is laminated on the upper surface of the encapsulating material layer 2.

As for the first phosphor layer 4, a phosphor-containing resin composition is first applied onto the upper surface of the mold releasing base material, which is not shown, for example, by a known coating method, to thereby form a phosphor-containing coating (not shown). As the mold releasing base material, the same material as the above-mentioned mold releasing base material 9 (FIG. 1(a)) can be used.

The phosphor-containing coating is then heated to be cured, so that the first phosphor layer 4 in a cured state is formed on the upper surface of the mold releasing base material.

Subsequently, the first phosphor layer 4 is transferred to the upper surface of the encapsulating material layer 2. Specifically, the first phosphor layer 4 is stuck to the upper surface of the encapsulating material layer 2, and then the mold releasing base material, which is not shown, is stripped off from the first phosphor layer 4.

This laminates the first phosphor layer 4 on the upper surface of the encapsulating material layer 2.

Thus, the encapsulating sheet 1 is obtained.

The encapsulating sheet 1 thus obtained can be appropriately cut into a predetermined size corresponding to the size of the substrate 14 and the light emitting diode 11 (see FIG. 2).

Next, a method for producing a light emitting diode device 15 by encapsulating the light emitting diode 11 using the encapsulating sheet 1 is described with reference to FIG. 2.

In this method, first, as shown in FIG. 2(a), an encapsulating sheet 1 and a substrate 14 are prepared.

Specifically, as shown in phantom lines in FIG. 1(d), an encapsulating sheet 1 is first prepared by removing the mold releasing base material 9 from the lower surfaces of the second phosphor layer 5 and the protruded portion 8.

The substrate 14 has a planar shape and the light emitting diode 11 is mounted in the center of the surface (upper surface) of the substrate 14 in the plane direction. The substrate 14 is formed slightly larger than the encapsulating sheet 1 in the plane direction.

The light emitting diode 11 is formed in a generally rectangular shape in section view.

The substrate 14 is provided with a terminal (not shown) formed on the upper surface thereof and a wire 12 electrically connected with the upper surface of the light emitting diode 11.

As shown in FIG. 2(a), the encapsulating sheet 1 is opposed on the upper side to the prepared substrate 14.

The encapsulating sheet 1 is arranged so that the protruded portion 8 of the encapsulating material layer 2 and the second phosphor layer 5 are directed toward the lower side.

In particular, the encapsulating sheet 1 is arranged so that the protruded portion 8 is opposed to and includes the light emitting diode 11 and the wire 12 when projected in the opposed direction (the up-and-down direction in FIG. 2)

Subsequently, as shown in FIG. 2(b), the encapsulating sheet 1 is stuck to the substrate 14 to encapsulate the light emitting diode 11.

Specifically, as shown by the arrows in FIG. 2(a), the encapsulating sheet 1 is stuck to the substrate 14 so that the second phosphor layer 5 is in contact with the upper surface of the substrate 14 and that the protruded portion 8 of the encapsulating material layer 2 embeds the light emitting diode 11 and the wire 12 in the lower surface thereof.

In the protruded portion 8 of the encapsulating material layer 2, a region in which the light emitting diode 11 is embedded is referred to as a diode embedding region 20 serving as an embedding region, and a region tightly adhered to the substrate 14 is referred to as a substrate adhering region 13. In the lower end portion of the side surface of the light emitting diode 11, the diode embedding region 20 and the substrate adhering region 13 overlap one another.

That is, as referred to FIG. 2(a), the substrate adhering region 13 of the protruded portion 8 adjoins to the inside of the second phosphor layer 5 and is defined as a generally annular shape in bottom view while the diode embedding region 20 of the protruded portion 8 adjoins to the inside the substrate adhering region 13 and is defined as a generally rectangular shape in bottom view.

In other words, in the encapsulating sheet 1, the diode embedding region 20 is spaced apart from the planar inner side of the second phosphor layer 5.

A maximum length D2 (an outer diameter) of the diode embedding region 20 is slightly larger than an outer diameter D3 of the light emitting diode 11 and is specifically, for example, from 1.1 to 10 times, or preferably 1.1 to 3 times as large as the outer diameter D3 of the light emitting diode 11.

As shown in FIG. 2(b), the light emitting diode 11 is press-fitted into the protruded portion 8 so as to be embedded therein.

Thus, the diode embedding region 20 in the protruded portion 8 of the encapsulating material layer 2 is tightly adhered to the upper surface and the peripheral side surface of the light emitting diode 11.

On the other hand, the substrate adhering region 13 in the protruded portion 8 of the encapsulating material layer 2 is tightly adhered to the upper surface of a first adjacent portion 16 which is adjacent outwardly to the light emitting diode 11 in the substrate 14.

Further, the lower surface of the second phosphor layer 5 comes in contact with the upper surface of a second adjacent portion 17 which is adjacent outwardly to the first adjacent portion 16 of the substrate 14.

Thereafter, in this method, when the encapsulating material layer 2 contains a thermosetting resin composition, the encapsulating material layer 2 is heated to be cured.

Referring to the heating conditions, the thermosetting resin composition of the encapsulating material layer 2 described above is completely cured. Specifically, in the case where the thermosetting resin composition is a silicone resin, an addition reaction (a hydrosilylation reaction) proceeds, and in the case where the silicone resin is a boron compound-containing silicone resin composition or an aluminum compound-containing silicone resin composition, a reaction thereof completely proceeds.

Specifically, the heating temperature is, for example, from 100 to 180°C and the heating time is, for example, from 1 to 100 minutes.

Further, at the same time as the heating described above, contact-bonding, that is, thermocompression bonding can be performed.

The heating temperature and the heating time are the same as those mentioned above and the pressure is, for example, over 0.1 MPa and 0.3 MPa or less.

In the case where the encapsulating material layer 2 contains a thermosetting resin composition, the heating or the thermocompression bonding described above causes the peripheral end portion 6 to overflow outwardly in the plane direction, so that the encapsulating material layer 2 is stuck to the substrate 14, which in turn sticking the encapsulating sheet 1 to the substrate 14, as are shown in FIG. 3.

In particular, when the encapsulating material layer 2 contains a thermosetting resin composition, the above heating softens the encapsulating material layer 2 to cause its peripheral end portion 6 to overflow outwardly, and the overflowed encapsulating material layer 2 exceeds the peripheral end edge of the second phosphor layer 5, to finally stick to the upper surface of the substrate 14 exposed from the second phosphor layer 5.

Thus, the light emitting diode 11 is encapsulated with the encapsulating sheet 1.

Therefore, a light emitting diode device 15 provided with the substrate 14, the light emitting diode 11, and the encapsulating sheet 1 stuck thereto to encapsulate the light emitting diode 11 can be obtained.

In the above-mentioned encapsulating sheet 1, since the second phosphor layer 5 is spaced apart from the diode embedding region 20, the second phosphor layer 5 is prevented from coming into contacting with the diode embedding region 20, so that the diode embedding region 20 of the encapsulating material layer 2 can reliably embed the light emitting diode 11. Therefore, the encapsulating sheet 1 can improve encapsulating property of the encapsulating material layer 2 to the light emitting diode 11.

Besides, the encapsulating sheet 1 includes a first phosphor layer 4 laminated on the upper surface of the encapsulating material layer 2 and a second phosphor layer 5 laminated on the lower surface of the encapsulating material layer 2. Therefore, in the light emitting diode device 15 having such encapsulating sheet 1 stuck thereto, a light radially spread from the light emitting diode 11 is converted its wavelength by the second phosphor layer 5, so that a light which does not pass through the first phosphor layer 4 and the second phosphor layer 5 can be reduced.

As a result, variation in the chromaticity of light emitted by the light emitting diode device 15 can be reduced.

According to the method for producing the light emitting diode device 15 using the encapsulating sheet 1, the light emitting diode 11 can be securely encapsulated, thereby allowing the light emitting diode device 15 to be reliably obtained.

In the embodiment described above, the opening 10 in the second phosphor layer 5 is formed in a generally annular shape in bottom view. However, the shape thereof is not particularly limited and the opening 10 can also be formed in, for example, a generally rectangular shape in bottom view.

FIG. 4 is a process diagram explaining a method for producing a light emitting diode device by encapsulating a light emitting diode using another embodiment (a mode in which an adhesive layer is provided) of the encapsulating sheet according to the present invention.

In the following drawings, the same reference numerals are provided for members corresponding to those described above and their detailed descriptions are omitted.

As shown in solid lines in FIG. 4(a), an adhesive layer 21 is laminated on the lower surface (surface) of the second phosphor layer 5 and the encapsulating sheet 1 can be adhered to the substrate 14 via the adhesive layer 21.

In FIG. 4(a), the adhesive layer 21 is formed of a known adhesive such as an epoxy adhesive, a silicone adhesive, or an acrylic adhesive, or preferably of a silicone adhesive. The adhesive layer 21 has a thickness of, for example, 1 to 100 µm, or preferably 5 to 50 µm.

The adhesive layer 21 is formed in a pattern in which a portion corresponding to the opening 10 in the second phosphor layer 5 is opened.

To laminate the adhesive layer 21 on the lower surface of the second phosphor layer 5, for example, as referred to FIG. 1(a), the above-mentioned adhesive layer 21 is first laminated on the entire upper surface of the mold releasing base material 9, and the second phosphor layer 5 is then laminated on the upper surface of the adhesive layer 21.

When the second phosphor layer 5 is laminated, the adhesive layer 21 is formed in a pattern in which a portion corresponding to the opening 10 in the second phosphor layer 5 is opened, together with the patterning of the phosphor-containing coating 60, as referred to the solid lines in FIG. 1(b).

Subsequently, the encapsulating material layer 2 and the first phosphor layer 4 are sequentially laminated.

Alternatively, as referred to FIG. 2(a), the encapsulating material layer 2, the first phosphor layer 4, and the second phosphor layer 5 are sequentially laminated and, in the encapsulating sheet 1 where the mold releasing base material 9 has been stripped off, the adhesive layer 21 is laminated (or coated) on the lower surface of the second phosphor layer 5 in the above-mentioned pattern, so that the adhesive layer 21 can be provided on the encapsulating sheet 1.

Providing of the adhesive layer 21 on the encapsulating sheet 1 enables the encapsulating sheet 1 to be adhered to the substrate 14, which can improve the encapsulating property of the encapsulating sheet 1 to the light emitting diode 11.

As seen in the embodiment shown in solid lines in FIG. 4(a), the adhesive layer 21 is provided only on the lower surface of the second phosphor layer 5. However, for example, as shown in phantom lines in FIG. 4(a), the adhesive layer 21 can be provided on the lower surface of the protruded portion 8 of the encapsulating material layer 2, as well as on the lower surface of the second phosphor layer 5.

In the embodiment shown in solid lines in FIG. 4, the adhesive layer 21 is preferably provided only on the lower surface of the second phosphor layer 5.

Thus, as shown in FIG. 4(a), since the adhesive layer 21 has an opening in the portion corresponding to the light emitting diode 11, the lower surface of the protruded portion 8 of the encapsulating material layer 2 is exposed as shown in FIG. 4(b). Therefore, as compared with the embodiment shown in phantom lines in FIG. 4(a), the encapsulating property of the light emitting diode 11 by the protruded portion 8 of the encapsulating material layer 2 can be improved.

### EXAMPLES

While in the following, the present invention is described in further detail with reference to Preparation Examples, Examples, and Comparative Example, the present invention is not limited to any of them by no means.

Preparation Example 1

(Preparation of Phosphor-Containing Resin Composition)

Added was 7.6 g of silicone elastomer (LR7665, manufactured by Wacker Asahikasei Silicone Co., Ltd.) to 2.4 g of Y₃Al₅O₁₂:Ce (YAG:Ce), and the mixture was stirred at room temperature to disperse YAG:Ce into the silicone elastomer, so that a phosphor-containing resin composition was prepared.

Preparation Example 2

(Preparation of Silicone Resin Composition)

With 2031 g (0.177 mol) of polydimethylsiloxane having silanol groups at both ends warmed to 40°C (polysiloxane having silanol groups at both ends, in the formula (1), all of R¹ are methyl, the average of n is 155, and the number average molecular weight thereof is 11,500), 15.76 g (0.106 mol) ofvinyltrimethoxysilane (alkenyl group-containing alkoxysilane) and 2.80 g (0.0118 mol) of (3-glycidoxypropyl) trimethoxysilane (epoxy group-containing alkoxysilane) were blended and then mixed with stirring.

The molar ratio (moles of SiOH group/moles of SiOCH₃ group) of the SiOH group of the polydimethylsiloxane having silanol groups at both ends to the SiOCH₃ group of the vinyltrimethoxysilane and (3-glycidoxypropyl) trimethoxysilane was 1/1.

After mixing with stirring, 0.97 mL of a methanol solution (condensation catalyst, 10% by mass concentration) of tetramethylammonium hydroxide (0.766 g, catalyst content: 0.88 mmol, equivalent to 0.50 mol per 100 mol of polydimethylsiloxane having silanol groups at both ends) was added thereto, and the mixture was stirred at 40°C for 1 hour. While the resulting mixture (oil) was stirred for 1 hour under a reduced pressure (10 mmHg) at 40°C, volatiles (methanol, etc.) were removed.

Thereafter, the system was brought back to normal pressure, 44.67 g (0.319 mol) of organohydrogensiloxane (in the formula (4), all of R⁴ are methyl, the average of a is 10, and the average of b is 10; a viscosity of 20 mPa·s at 25°C) was added to the reactant, and the mixture was stirred at 40°C for 1 hour.

The molar ratio (CH₂=CH-/SiH) of the vinyl group (CH₂=CH-) of the vinyltrimethoxysilane to the hydrosilyl group (SiH group) of the organohydrogensiloxane was 1/3.

Subsequently, 0.13 g (0.13 mL, a platinum content of 2% by mass, equivalent to 1.2 x 10⁻⁴ parts by mass per 100 parts by mass of organohydrogensiloxane as platinum) of a platinum-carbonyl complex oligosiloxane solution (addition catalyst, platinum concentration of 2% by mass) was added to the system and the mixture was stirred at 40°C for 10 minutes.

Thus, a silicone resin composition was prepared.

Example 1

The phosphor-containing resin composition of Preparation Example 1 was applied over the entire upper surface of a mold releasing base material (see FIG. 1(a)) made from polyester film (SS4C, manufactured by Nippa Co., Ltd.) with an applicator to form a phosphor-containing coating(see phantom lines in Fig. 1 (b)). A center portion of the phosphor-containing coating were then removed by half-cutting, so that the phosphor-containing coating was patterned into an opening shape having an inner diameter (D1) of 5 mm.

Thereafter, the phosphor-containing coating was cured by heating at 100°C for 10 minutes, to thereby form a second phosphor layer in a cured state having a thickness (T3) of 100 µm (see solid lines in FIG. 1(b)).

Next, the silicone resin composition of Preparation Example 2 was applied over the entire upper surface of the second phosphor layer containing the mold releasing base material with an applicator, to thereby form an encapsulating coating. Subsequently the encapsulating coating thus formed was heated at 135°C for 5 minutes, so that an encapsulating material layer in a B-stage having a thickness (T1, a maximum thickness) of 1 mm (1000 µm) was laminated (see FIG. 1(c)).

A protruded portion filled in an opening in the second phosphor layer was formed in the encapsulating material layer.

The phosphor-containing resin composition of Preparation Example 1 was separately applied over the entire upper surface of the mold releasing base material made from polyester film (SS4C, produced by Nippa Co., Ltd.) with an applicator, to thereby form a phosphor-containing coating. Subsequently, the phosphor-containing coating was cured by heating at 100°C for 10 minutes, so that a first phosphor layer in a cured state having a thickness of 100 µm was formed.

Thereafter, the first phosphor layer was transferred to the upper surface of the encapsulating material layer, so that the first phosphor layer was laminated on the upper surface of the encapsulating material layer (see FIGS. 1(d) and 2(a)).

Thus, an encapsulating sheet was produced.

The encapsulating sheet was then cut a 1 cm square portion around the opening in the second phosphor layer.

After the mold releasing base material was stripped off from the encapsulating sheet, the encapsulating sheet was stuck to the surface of a substrate (20 x 20 mm in size and 0.5 mm in thickness) on which a light emitting diode (a generally rectangular shape in plan view having a size of 3 x 3 mm (a maximum length D3 of 4.2 mm) and a thickness of 0.3 mm) was mounted and which was connected with the light emitting diode by wire (see FIG. 2(b)).

In other words, the encapsulating sheet was stuck to the substrate so that the second phosphor layer was in contact with the upper surface of the substrate and that the protruded portion of the encapsulating material layer embedded the light emitting diode and the wire in the lower surface thereof.

In particular, the encapsulating sheet was stuck to the substrate so that a diode embedding region in the protruded portion of the encapsulating material layer was tightly adhered to the upper surface and the peripheral side surface of the light emitting diode, a substrate adhering region in the protruded portion of the encapsulating material layer was tightly adhered to the upper surface of a first adjacent portion of the substrate, and the lower surface of the second phosphor layer was in contact with the upper surface of a second adjacent portion of the substrate.

In the protruded portion of the encapsulating material layer, the diode embedding region had an outer diameter (D2) of 4.5 mm (i.e., 1.1 times larger than the outer diameter (D3) 4.2 mm of the light emitting diode), and the substrate adhering region had a width of 0.25 mm.

Specifically, the encapsulating sheet was stuck to the substrate and the light emitting diode in the above-mentioned arrangement, and was then heated under normal pressure (0.1 MPa) at 160°C for 5 minutes.

Thus, the encapsulating material layer was cured and the light emitting diode was encapsulated with the encapsulating sheet, to thereby produce a light emitting diode device.

Example 2

A light emitting diode device was produced by encapsulating a light emitting diode in the same manner as in Example 1 except that the adhesive layer having a thickness of 40 µm made of silicone adhesive was laminated only on the lower surface of the second phosphor layer (see FIG. 4(a)) and the encapsulating sheet was adhered to the substrate via the adhesive layer (see FIG. 4(b)).

Comparative Example 1

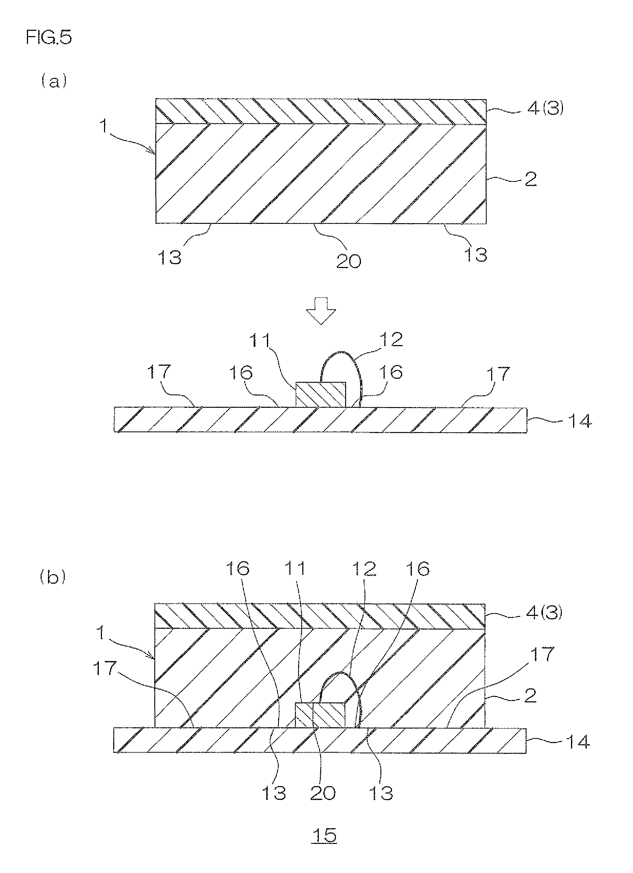

A light emitting diode device was produced by producing an encapsulating sheet, followed by encapsulating of a light emitting diode with the encapsulating sheet in the same manner as in Example 1 except that the second phosphor layer was not provided (see FIG. 5(b)).

That is, the phosphor layer was formed only from the first phosphor layer (see FIG. 5(a)).

(Evaluation)

### 1. Angular Dependence of Chromaticity

With the light emitting diode device (1) of each of Examples 1 and 2, and Comparative Example 1, an electric current of 250 mA was applied to the light emitting diode (11) to turn on the light emitting diode (11). Then, the CIE chromaticity indices (y values) were determined.

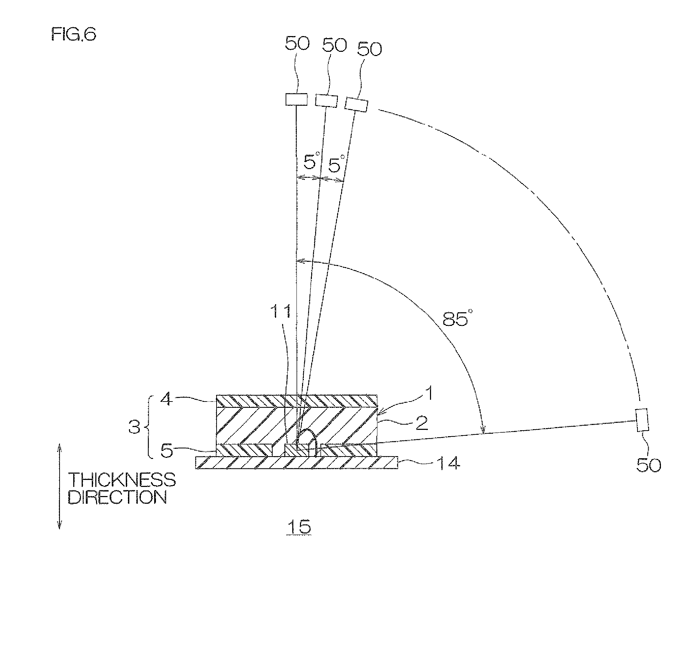

Specifically, as referred to FIG. 6, a detector (50) was moved in 5 degree increments away from a position above the light emitting diode (11) of the light emitting diode device (1) (i.e., a position where an angle (a detection angle) formed between the thickness direction of the light emitting diode device (1) and a direction (a detection direction) of a line segment which connects the centers of the detector (50) and the light emitting diode (11) is 0 degree; a 0-degree position hereinafter referred to the same.) to a position lateral to the light emitting diode (11) of the light emitting diode device (15) (a 85-degree position), to thereby determine the CIE chromaticity indices (y values).

As the measuring device including a detector (50), a multi-channel photo detector (MCPD-9800, produced by Otsuka Electronics Co., Ltd.) was used.

Table 1 shows y values at 0 degree, maximum y values, their detection angles (angles between the detection direction and the thickness direction), minimum y values, their angles (angles with respect to the thickness direction), and values obtained by subtracting the minimum y values from the maximum y values.

[Table 1]

**[TABLE 1]**

| Ex. Comp. Ex | Ex. 1 | Ex. 2 | Comp. Ex. 1 |
|---|---|---|---|
| y Value | 0.314 | 0.315 | 0.313 |
| (Detection Angle*) | (0°) | (0°) | (0°) |
| Max. y Value | 0.352 | 0.353 | 0.35 |
| (Detection Angle*) | (75°) | (75°) | (70°) |
| Min, y Value and Angle | 0.314 | 0.315 | 0.307 |
| (Detection Angle*) | (0°) | (0°) | (85°) |
| Max. y Value | 0.038 | 0.038 | 0.043 |
| - Min. y Value | | | |

| | | | |
|---|---|---|---|
| * Detection Angle: Angle formed between the detection direction and the thickness direction | | | |

### 2. Determination of Tensile Modulus

The tensile modulus at 25°C of the encapsulating material layer in each of Examples 1 and 2, and Comparative Example 1 was determined by an Autograph (AGS-J, produced by Shimadzu Corp.).

The results showed that each of the encapsulating material layers had a tensile modulus at 25°C of 0.08 MPa.

## Claims

1. An encapsulating sheet for sticking to a substrate mounted with a light emitting diode and encapsulating the light emitting diode, comprising:
an encapsulating material layer in which an embedding region is defined, the embedding region for embedding the light emitting diode from one side surface of the encapsulating material layer;
a first phosphor layer laminated on the other side surface of the encapsulating material layer; and
a second phosphor layer laminated on one side surface of the encapsulating material layer so as to be spaced apart from the embedding region.

2. The encapsulating sheet according to claim 1, wherein the encapsulating material layer has a tensile modulus at 25°C of 0.01 MPa or more.

3. The encapsulating sheet according to claim 1, further comprising an adhesive layer laminated on a surface of the second phosphor layer.

4. A method for producing a light emitting diode device comprising the step of sticking an encapsulating sheet to a substrate mounted with a light emitting diode to encapsulate the light emitting diode, wherein
the encapsulating sheet comprises
an encapsulating material layer in which an embedding region is defined, the embedding region for embedding the light emitting diode from one side surface of the encapsulating material layer;
a first phosphor layer laminated on the other side surface of the encapsulating material layer; and
a second phosphor layer laminated on one side surface of the encapsulating material layer so as to be spaced apart from the embedding region.

5. The method for producing the light emitting diode device according to claim 4, wherein the encapsulating sheet is stuck to the substrate so that an end portion in a direction perpendicular to a thickness direction of the encapsulating material layer overflows outwardly by heating to stick to the substrate.

6. A light emitting diode device comprising:
a substrate;
a light emitting diode mounted on a surface of the substrate; and
an encapsulating sheet stuck on the surface of the substrate to encapsulate the light emitting diode, wherein
the encapsulating sheet comprises
an encapsulating material layer in which an embedding region is defined, the embedding region for embedding the light emitting diode from one side surface of the encapsulating material layer;
a first phosphor layer laminated on the other side surface of the encapsulating material layer; and
a second phosphor layer laminated on one side surface of the encapsulating material layer so as to be spaced apart from the embedding region.
